(19) Europäisches Patentamt
European Patent Office
Office européen des brevets

(11) Publication number: 0 125 599 B1

(12) EUROPEAN PATENT SPECIFICATION

(45) Date of publication of patent specification: 01.07.87

(51) Int. Cl.$^4$: C 08 J 5/18, C 08 L 79/08

(21) Application number: 84105130.3

(22) Date of filing: 07.05.84

# (54) Process for producing copolymer films.

(30) Priority: 09.05.83 JP 79437/83

(43) Date of publication of application: 21.11.84 Bulletin 84/47

(45) Publication of the grant of the patent: 01.07.87 Bulletin 87/27

(84) Designated Contracting States: AT CH DE FR GB IT LI NL

(58) References cited:
FR-A-1 604 873
FR-A-2 197 034
GB-A- 903 272

(73) Proprietor: MITSUI TOATSU CHEMICALS, INCORPORATED
2-5 Kasumigaseki 3-chome
Chiyoda-Ku Tokyo 100 (JP)

(72) Inventor: Sato, Takushi
29-12, Torigaoka Totsuka-ku
Yokohama Kanagawa-Ken (JP)
Inventor: Kawamata, Motoo
2261-24, Kamigocho Totsuka-ku
Yokohama Kanagawa-Ken (JP)
Inventor: Takahashi, Shigeru
Mitsui Toatsu Apaato 1-3-6 2882, Iijimacho
Totsuka-ku Yokohama Kanagawa-Ken (JP)
Inventor: Ibi, Akira Mitsui Toatsu Apaato 4-37
2882 Iijimacho Totsuka-ku
Yokohama Kanagawa-Ken (JP)
Inventor: Naito, Mituyuki
1-27-10, Shinmachi
Setagaya-ku Tokyo (JP)
Inventor: Shindo, Kazumi
Mitsui Toatsu Zushi Ryo 4-10-8, Hisagi
Zushi Kanagawa-Ken (JP)
Inventor: Shishido, Shigeyuki
Mitsui Toatsu Shataku 4-5-10, Dai
Kamakura Kanagawa-Ken (JP)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 125 599 B1

(74) Representative: **Schüler, Horst, Dr. European Patent Attorney**
**Kaiserstrasse 41**
**D-6000 Frankfurt/Main 1 (DE)**

**Description**

Background of the invention

1. Field of the invention

This invention relates to a process for producing polyamide-polyimide block copolymer films or polyamide-polyimide copolymer films having excellent thermal resistance and mechanical strength according to the solution casting technique.

2. Description of the prior art

With the recent widening of application of electronics to apparatus and equipment, flexible printed circuits which can be bent at will have found an increasingly greater variety of uses because they can be mounted in apparatus and equipment with a high degree of freedom and they permits the size and weight of the latter to be reduced easily. As a result, increasingly higher performance has come to be required of plastic films which constitute the base of such circuits. Moreover, the size and weight reduction of electrical apparatus and equipment has posed a vital problem concerning their temperature rise due to the evolution of heat. In order to solve this problem, electrical insulating films having more excellent thermal resistance have come to be used in such electrical apparatus and equipment.

Heat-resisting films such as aromatic polyimide films, polyester films and the like are known to be useful as base films for flexible printed circuits and electrical insulating films. However, these films are disadvantageous in that aromatic polyimide films are very expensive and the polyester films are poor in thermal resistance.

In order to solve these problems, polyamide-polyimide block copolymer films and polyamide-polyimide copolymer films have been proposed in Japanese Patent Publication Nos. 28077/'78 and 44891/'81, respectively. However, these polyamide-polyimide block copolymer films and polyamide-polyimide copolymer films are markedly inferior in thermal resistance to aromatic polyimide films and, moreover, do not have satisfactorily high mechanical strength.

Summary of the invention

It is an object of the present invention to provide a process for producing polyamide-polyimide block copolymer films or polyamide-polyimide copolymer films which have excellent thermal resistance and mechanical strength and, therefore, are useful as base films for printed circuits or as electrical insulating films.

According to the present invention, there is provided a process for producing polyamide-polyimide block copolymer films or polyamide-polyimide copolymer films which comprises (1) casting on a substrate

(a) a solvent solution of a polyamide-polyamide acid block copolymer having repeating structural units of the formula

$$-[(A)-(E)]-_n \qquad (I)$$

where n represents a whole number of 1 to 500, A represents a polyamide block having structural units of the formula

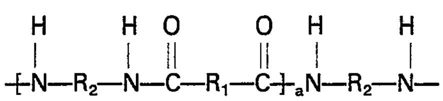

(II)

or

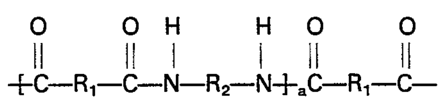

(III)

and E represents a polyamide acid block having structural units of the formula

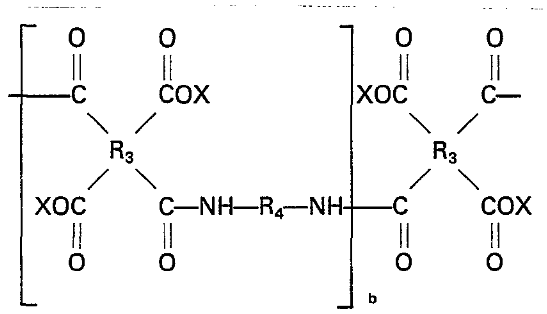

(IV)

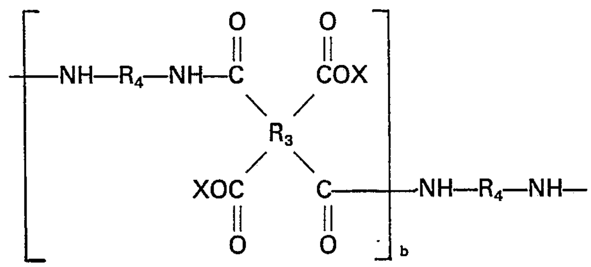

(V)

or

(b) a solvent solution of a polyamide-polyamide acid copolymer obtained by reacting a polyamide acid of the formula

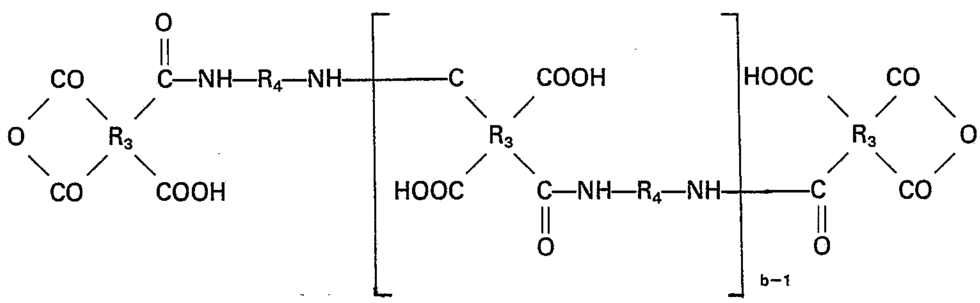

(VI)

or

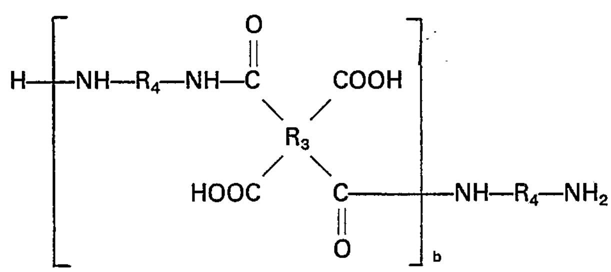

(VII)

with a dicarboxylic acid dichloride of the formula

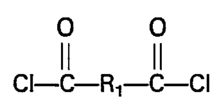

(IX)

and a diamine of the formula

$$H_2N—R_2—NH_2 \qquad (X)$$

where, in the formulas (II) to (X), a and b independently represent whole numbers of 2 to 100, $R_2$ and $R_4$ independently represent monocyclic aromatic groups which may be substituted with one or more halogen atoms, alkyl groups of 1 to 4 carbon atoms, or alkoxy groups of 1 to 4 carbon atoms, unfused bicyclic aromatic groups in which the aromatic nuclei are linked together by the bridge member —O—, —$CH_2$—, —CO— or —$SO_2$— and they may be substituted with one or more halogen atoms, alkyl groups of 1 to 4 carbon atoms or alkoxy groups of 1 to 4 carbon atoms, heterocylic groups, alkylene groups of 2 to 12 carbon atoms, or dicyclohexylmethane groups, $R_1$ represents an aromatic group, a heterocyclic group or an alkylene group of 2 to 8 carbon atoms in which the carbonyl groups are bonded to different carbon atoms, $R_3$ represents a five- or six-membered cycloalkyl group, a benzene ring or an unfused bicyclic aromatic group in which the aromatic nuclei are linked together by the bridge member —O—, —CO— or —CONH— and the carbonyl groups are bonded to different ring carbon atoms that are adjacent in pairs, and X represents a halogen atom or an alkyl group of 1 to 4 carbon atoms;

(2) converting the deposited thin layer of the solution into a self-supporting film; (3) separating the self-supporting film from the substrate; and characterized by (4) heating the self-supporting film having a residual solvent content of 40% by weight or less at a temperature of 320° to 500°C for a period of time ranging from 5 seconds to 90 minutes.

Detailed description of the invention

The polyamide-polyimide block copolymer films to which the present invention is directed are those comprising a resin having repeating structural units of the formula

$$-\!\!\!+\!(A_1)\!-\!(E_1)\!+\!\!\!-_n \qquad (XI)$$

where $A_1$ is a polyamide block having structural units of the formula

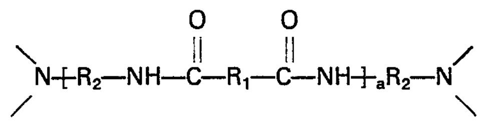

(XII)

or

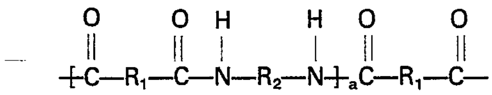

(III)

and $E_1$ is a polyimide block having structural units of the formula

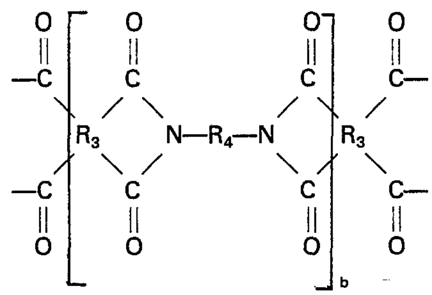

(XIII)

or

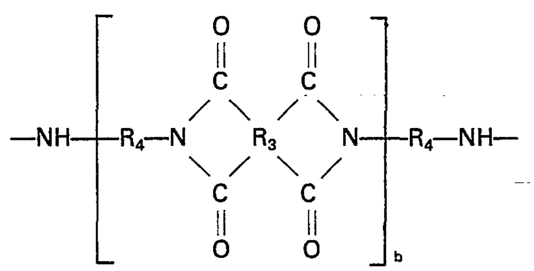

(XIV)

In the above formulas XI to XIV, n, a, b, $R_1$, $R_2$, $R_3$ and $R_4$ have the same meanings as given for formulas I to X.

The polyamide-polyimide copolymer films to which the present invention is directed are those comprising a resin obtained by reacting a polyamide acid of the above formula (VI) or (VII) with a dicarboxylic acid dichloride of the above formula (IX) and a diamine of the above formula (X) and then cyclizing the resulting polyamide-polyamide acid copolymer.

The polyamide-polyamide acid block copolymers and the polyamide-polyamide acid copolymers which are useful in the practice of the present invention can be prepared, for example, by the processes described in Japanese Patent Publication Nos. 28077/'78 and 44891/'81, respectively.

In the practice of the present invention, polyamide-polyimide block copolymer films or polyamide-polyimide copolymer films are produced according to the so-called solution casting technique. More specifically, a polyamide-polyamide acid block copolymer or a polyamide-polyamide acid copolymer is dissolved in a suitable solvent. Useful solvent include, for example, N,N-dimethylacetamide, N,N-diethylacetamide, N,N-dimethylformamide, N,N-dimethylmethoxyacetamide, N-methyl-2-pyrrolidone, N-acetyl-2-pyrrolidone, N-methyl-ε-caprolactam, hexamethylphosphoric acid triamide (commonly known as hexametapol), N,N,N',N'-tetramethylurea, tetrahydrothiophene dioxide (commonly known as sulfolane), dimethyl sulfoxide, m-chlorophenol, p-chlorophenol, 3-chloro-6-hydroxytoluene, sulfuric acid and the like, as well as mixtures of the foregoing. The resulting solution is cast or coated on a substrate to deposit a thin layer of the solution, which is converted into a self-supporting film. This self-supporting film is then separated from the substrate.

The substrate used for this purpose usually comprises a metal roll, a metal belt or a solvent-resistant resin film. However, there may be used any other substrate, such as a glass plate, a metal plate, a solvent-resistant resin plate or the like, that is not deformed by applying thereto the solvent solution of the copolymer. Moreover, such a film can be continuously be produced by using a combination of revolving metal rolls and a metal belt, or a continuous solvent-resistant resin film.

The thin layer of the polyamide-polyamide acid block copolymer or polyamide-polyamide acid copolymer solution deposited on the substrate can be converted into a self-supporting film by using any of various techniques such as heating, cyclization with a cyclizing agent, extraction, exposure to electromagnetic waves or radiation, evaporation under reduced pressure, air-drying and the like.

In the case of heating, the self-supporting property is imparted to the thin layer by heating it in a vacuum or under atmospheric pressure at a temperature usually ranging from 50° to 250°C. The self-supporting film so formed can now be separated from the substrate.

Where it is desired to form a self-supporting film by cyclization with a cyclizing agent, the polyamide-polyamide acid block copolymer or polyamide-polyamide acid copolymer can be readily cyclized into a polyamide-polyimide block copolymer or polyamide-polyimide copolymer, respectively, by adding a cyclizing agent alone or a mixture of a cyclizing agent and a catalyst (such as a tertiary amine or the like) to the thin layer, or bringing the thin layer into contact with a solution containing a cyclizing agent alone or a mixture of a cyclizing agent and a catalyst, and then heat-treating the thin layer at a temperature of 20° to 200°C. Examples of the cyclizing agent include acetic anhydride, propionic anhydride and dicyclohexylcarbodiimide. Typical examples of the mixture of a cyclizing agent and a catalyst include mixtures of acetic anhydride and pyridine, picoline or triethylamine.

The thin layer of the polyamide-polyamide acid block copolymer or polyamide-polyamide acid copolymer solution can also be converted into a self-supporting film by using the so-called extraction technique in which the thin layer is brought into contact with an extractant (such as water or an extraction solvent) to remove the solvent from the thin layer.

A particularly important step of the process of the present invention is the step of heat-treating the self-supporting film separated from the substrate. This step is carried out by reducing the residual solvent content of the film to 40% by weight or less, preferably 20% by weight or less and most preferably 5% by weight or less by heating at relatively low temperatures, evaporation under reduced pressure, extraction or air drying, if necessary, and then heating the film at a temperature of 320° to 500°C for a period of time ranging from 5 seconds to 90 minutes. This treatment provides the film not only with such a degree of thermal resistance as can prevent the film from being deformed in a solder bath at 260°C, but also with excellent mechanical properties such as tensile break strength, tensile elongation and the like. If this treatment is omitted, the resulting film will be insufficient in thermal resistance to be useful as a base film for flexible printed circuits in that it will have a low glass transition temperature (hereinafter referred to as $T_g$) as measured by the penetration method (hereinafter referred to as the TMA method) using a thermophysical tester and will undergo deformation upon contact with molten solder at 260°C.

The reason why the thermal resistance, mechanical strength and like properties of the self-supporting film are improved by heat treatment at a temperature of 320° to 500°C has not been completely elucidated. However, if electron spin resonance spectra (hereinafter referred to as ESR spectra) are recorded with an electron spin resonance absorption apparatus and compared, it will be recognized that that greater number of radicals are formed in the films produced by the process of the present invention than in conventional polyamide-polyimide block copolymer films and polyamide-polyimide copolymer films. Moreover, conventional films have a fraction soluble in solvents such as sulfuric acid and the like, but the films of the present invention are completely insoluble. Thus, the films of the present invention also show an improvement in chemical resistance.

On the basis of these facts, the films of the present invention are considered to have a three-dimensional network structure in which cross-linking has occurred within or among the molecular chains constituting the film. In contrast, it seems that, at temperatures lower than 320°C, no adequate number of radicals are formed and no sufficient degree of cross-linking reaction for the improvement of properties takes place, resulting in a failure to achieve an improvement in thermal resistance and mechanical properties. It is generally known that a similar improvement in properties may be brought about by cyclization of polymers. However, the cyclization of polyamide-polyamide acid block copolymers and polyamide-polyamide acid copolymers into polyamide-polyimide block copolymers and polyamide-polyimide copolymers, respectively, is usually completed to a substantial degree at temperatures lower than 300°C, whether it may be carried out according to a conventional thermal method or a chemical method using a cyclizing agent. Accordingly, such improvement in properties are substantially different from that obtained by heating the film at a temperature of 320° to 500°C in accordance with the present invention.

As described above, the heating temperature may range from 320° to 500°C and preferably from 340°C to 450°C. At higher temperatures within this range, satisfactory results can be obtained in a short period of time, while at lower temperatures within this range, it is necessary to heat the film for a relatively long period of time. If the heating temperature is lower than 320°C, the effect of improving thermal resistance and the like will be insufficient, and if it is higher than 500°C, the performance of the film will undergo a marked degree of deterioration by heat.

The heating at a temperature of 320° to 500°C is preferably carried out in a vacuum or in an inert gas such as nitrogen or the like. Where the heating is carried out in air, the performance of the film may be deteriorated by oxidation. Accordingly, it is desirable to heat the film rapidly by exposure to electromagnetic waves (such as infrared rays or microwaves) or radiation and then cool it rapidly so that the film may be exposed to high temperatures for as short a period of time as possible. However, hot air

may be used so long as care is taken to heat and cool the film in a short period of time, for example, by blowing the hot air against the film at high velocity.

Where the heating step is carried out by means of a high-temperature fluid (such as hot air, a heated inert gas, combustion gas or the like), electromagnetic waves (such as infrared rays, microwaves or the like) or radiation, a substantially satisfactory effect can be obtained by heating the film for a period of time usually ranging from 5 seconds to 90 minutes and preferably 30 seconds to 30 minutes, though it depends on the structure of the film, the heating temperature and the like. If the heating time is shorter than 5 seconds, the effects of the present invention cannot be obtained, and if it is longer than 90 minutes, deterioration of the film will result. The residual solvent content of the self-supporting film separated from the substrate is usually greater than 0.1% by weight. It it is greater than 40% by weight, the solvent present in the film is vigorously evaporated by exposure to a temperature of 320°C or above, resulting in a film having irregular surfaces or, in the worst case, a porous film. Such films show a reduction in mechanical strength, electrical properties and the like, so that they are unsuitable for use in applications other than some special ones. Accordingly, if the residual solvent content of the self-supporting film is greater than 40% by weight, it is desirable, as described above, to reduce the residual volatile content to 40% by weight or less, preferably 20% by weight or less and most preferably 5% by weight or less by heating at temperatures lower than 320°C, evaporation under reduced pressure, extraction, air-drying or other means, prior to the heat treatment of the present invention.

Conveniently, the step of heating the self-supporting film at a temperature of 320° to 500°C to improve its properties is carried out immediately following the preceding film-forming step. However, it is also possible to produce a semi-finished film in one stage and then heat it in another stage.

It is efficient to heat the self-supporting film simultaneously on both sides, though it may be heated on a single side. From an operational point of view, this heating step is facilitated by holding two or four edges of the self-supporting film at a constant width with fabric fasteners such as pin sheets, clips and the like. However, it is also possible to heat the self-supporting film while increasing or decreasing the width gradually.

The polyamide-polyamide acid block copolymers and polyamide-polyamide acid copolymers which are useful in the practice of the present invention should preferably have a logarithmic viscosity number ($\eta_{inh}$) of 0.1 to 3.0, more preferably 0.5 to 2.0, as measured by a 0.5 g/100 ml solution in N,N-dimethylacetamide at 35°C. The film-forming conditions and the like are controlled by utilizing the logarithmic viscosity number as a guide.

As described in detail hereinabove, the process of the present invention makes it possible to produce polyamide-polyimide block copolymer films and polyamide-polyimide copolymer films having such a high degree of thermal resistance as has never been achieved by conventional processes and, moreover, showing an improvement in mechanical properties such as tensile break strength, tensile elongation and the like.

The process of the present invention is further illustrated by the following examples.

In these examples, the logarithmic viscosity number ($\eta_{inh}$) of a polymer as measured by a 0.5 g/100 ml solution in N,N-dimethylacetamide at 35°C is defined by the following equation:

$$\eta_{inh}=\frac{1n(\eta/\eta_0)}{C}$$

where $\eta$ is the viscosity of the solution, $\eta_0$ is the viscosity of the solvent, and C is the polymer concentration (in g/100 ml) in the solution.

In these examples, the apparent electron spin ($S_p$) of a film as measured with an ESR apparatus is defined by the following equation:

$$S_p=\frac{S}{A\cdot W}$$

where S is the area bounded by the ESR spectrum and the horizontal axis indicating the intensity of the magnetic field, A is the measuring sensitivity, and W is the amount of sample used.

Besides the logarithmic viscosity number and apparent electron spin, the glass transistion temperature ($T_g$) of a film was determined according to the TMA method, and the tensile break strength and tensile elongation of a film were determined according to the methods described in JIS P-8113.

Example 1

A. Preparation of an amino-terminated polyamide

Within a 1-liter reactor fitted with a stirrer, an internal thermometer, a dropping funnel having a pressure equalizing tube, and a nitrogen inlet tube, 6.84 g of 4,4'-diaminodiphenyl ether was completely dissolved in 40 g of anhydrous N,N-dimethylacetamide. While the internal temperature of the reactor was kept within the range of −5° to 0°C by passing a coolant through the jacket, a solid mixture of 2.46 g (0.0121

mole) of isophthaloyl dichloride and 2.46 g (0.0121 mole) of terephthaloyl dichloride was added to the above solution, little by little, under an atmosphere of nitrogen. After completion of the addition, the resulting viscous reaction mixture was warmed to 10°C and stirred for 1 hour.

Then, while this reaction mixture was kept at a temperature of 5° to 10°C, 3.09 g (0.0532 mole) of propylene oxide diluted with 6 g of anhydrous N,N-dimethylacetamide was added thereto drop by drop. After completion of the addition, the reaction mixture was stirred at 5—10°C for 1 hour to obtain an aminoterminated polyamide having an average molecular weight of 1,000 as calculated on a theoretical basis.

B. Preparation of an acid anhydride-terminated polyamide acid

Within the same reactor as described in the above procedure A, 27.1 g (0.124 mole) of pyromellitic acid dianhydride was suspended in 41 g of anhydrous N,N-dimethylacetamide. While this suspension was kept at a temperature of 5° to 20°C, 22.9 g (0.114 mole) of 4,4'-diaminodiphenyl ether dissolved in 92 g of anhydrous N,N-dimethylacetamide was added thereto, drop by drop, under an atmosphere of nitrogen. The viscosity of the mixture rose as the amine solution was added. Accordingly, when 75% of the amine solution was added, 67 g of anhydrous N,N-dimethylacetamide was added in order to control the viscosity of the mixture. After completion of the addition, the resulting reaction mixture was stirred at 20—25°C for 1 hour to obtain an acid anhydride-terminated polyamide acid having an average molecular weight of 5,000 as calculated on a theoretical basis.

C. Preparation of a polyamide-polyamide acid block copolymer

The amino-terminated polyamide solution obtained by the procedure A was added to the acid anhydride-terminated polyamide acid solution obtained by the procedure B. This addition was carried out under an atmosphere of nitrogen at 15—20°C over a period of about 30 minutes. Moreover, 89 g of N,N-dimethylacetamide was added and the resulting mixture was stirred at 20—25°C for 2 hours. Thus, there was obtained a viscous solution containing 15.0% by weight of a polyamide-polyamide acid block copolymer having an inherent viscosity of 1.62 (as measured by a 0.5 g/100 ml solution in N,N-dimethylacetamide at 35°C).

D. Formation of a polyamide-polyimide block copolymer film

The polyamide-polyamide acid block copolymer solution obtained by the procedure C was cast on a glass plate by means of an applicator having a clearance of 0.7 mm, and then dried in a stream of air at 150°C for 30 minutes. The self-supporting film so formed was separated. This film was stretched over a metal frame having pins set therein, dried in a stream of air at 200°C for 60 minutes to reduce the residual solvent content to 0.4% by weight, and then heated at 350°C for 60 minutes. Properties of the polyamide-polyimide block copolymer film thus obtained are shown in Table 2.

Example 2

A film was produced by employing the same procedures and conditions as described in Example 1, except that the heating was carried out at 450°C for 1 hour. Properties of the film thus obtained are shown in Table 2.

Comparative Examples 1 and 2

Films were produced by employing the same procedures and conditions as described in Example 1, except that the heating was carried out at 300°C for 60 minutes in Comparative Example 1 and at 340°C for 100 minutes in Comparative Example 2. Properties of the films thus obtained are shown in Table 2.

Example 3

32.1 g (0.100 mole) of benzophenonetetracarboxylic acid dianhydride was suspended in 48 g of N,N-dimethylacetamide. While this suspension was kept at a temperature of 5° to 20°C, 17.9 g (0.0896 mole) of 4,4'-diaminodiphenyl ether dissolve in 72 g of N,N-dimethylacetamide was added thereto drop by drop. Since the viscosity of the mixture rose as the amine solution was added, 80 g of N,N-dimethylacetamide was added thereto upon occasion. After completion of the addition, the resulting reaction mixture was stirred at 5—20°C for 1 hour to obtain a polyamide acid solution. To this solution was added 31.1 g (0.156 mole) of 4,4'-diaminodiphenyl ether dissolved in 180 g of N,N-dimethylacetamide. The resulting mixture was cooled to a temperature of −5° to 0°C.

Then, while the above reaction mixture was kept at a temperature of −5° to 0°C, a solid mixture of 14.8 g (0.0729 mole) of isophthaloyl dichloride and 14.8 g (0.0729 mole) of terephthaloyl dichloride was added thereto little by little, and the resulting reaction mixture was stirred for an additional hour. Thereafter, while this reaction mixture was kept at a temperature of 5° to 10°C, 18.6 g (0.320 mole) of propylene oxide diluted with 37 g of N,N-dimethylacetamide was added thereto drop by drop. After the addition of 120 g of N,N-dimethylacetamide, the reaction mixture was stirred at 5—10°C for 2 hours to obtain a viscous solution containing 15% by weight of a polyamide-polyamide acid copolymer having an inherent viscosity of 1.60. Using this polymer solution, a film was produced according to the procedure D of Example 1. Properties of the polyamide-polyimide copolymer film thus obtained are shown in Table 2.

Example 4

According to the procedures A, B and C of Example 1, a polyamide-polyamide acid block copolymer solution having a polymer concentration of 15.0% by weight was prepared by using the starting material formulation shown in Table 1.

Acetic anhydride and β-picoline were added to and mixed with the above polymer solution in such amounts that the —COOH groups of the polymer, acetic anhydride and β-picoline were present in a molar ratio of 1:2:0.25. The resulting mixture was cast on a glass plate by means of an applicator having a clearance of 0.7 mm. This glass plate was placed on a hot plate and heated at 100°C for 1 minute. The self-supporting gel-like film so formed was separated from the glass plate. This film was stretched over a metal frame having pins set therein, and dried in a stream of nitrogen at 150°C for 5 minutes. At this time, the residual solvent content of the film was 15% by weight. Then, the film was heated at 350°C for 60 minutes. Properties of the film thus obtained are shown in Table 2.

Example 5

According to the procedures A, B and C of Example 1, a polyamide-polyamide acid block copolymer solution having a polymer concentration of 15.0% by weight was prepared by using the starting material formulation shown in Table 1.

This polymer solution was cast on a glass plate by means of an applicator having a clearance of 0.7 mm, and dried in a stream of air at 150°C for 30 minutes. The self-supporting film so formed was separated. This film was stretched over a metal frame having pins set therein, dried in a stream of air at 200°C for 60 minutes, and then heated at 320°C for 15 minutes. Properties of the film thus obtained are shown in Table 2.

Example 6

According to the procedures A, B and C of Example 1, a polyamide-polyamide acid block copolymer solution having a polymer concentration of 15.0% by weight was prepared by using the starting material formulation shown in Table 1.

This polymer solution was cast on a glass plate by means of an applicator having a clearance of 0.7 mm. This glass plate was placed on a hot plate and heated at 60°C for 15 minutes to remove a part of the solvent. Then, the glass plate carrying the polymer film was soaked in water at 20°C for 4 hours and the self-supporting film so formed was separated. This film was stretched over a metal frame having pins set therein, dried in a stream of nitrogen at 150°C for 30 minutes and then 200°C for 60 minutes, and then heated under an atmosphere of nitrogen for 15 minutes by means of an infrared heater controlled in such a way that a thermocouple positioned in contact with a surface of the film indicated a temperature of 320°C. Properties of the film thus obtained are shown in Table 2.

Example 7

According to the procedures A, B and C of Example 1, a polyamide-polyamide acid block copolymer solution having a polymer concentration of 15.0% by weight was prepared in a 100-liter reactor by using the starting material formulation shown in Table 1. This polymer solution was filtered, vacuum defoamed and fed, by means of a gear pump, to a T-die having a slit width of 0.4 mm and a slit length of 300 mm. Through this T-die, the polymer solution was continuously cast on a steel belt traveling at a speed of 0.3 m/min. Then, the steel belt was passed through a drying oven having a length of 3 meters, in which the steel belt was exposed to a stream of nitrogen whose temperature gradually rose from 100°C at the entrance to 150°C at the exit. At the exit of the oven, the self-supporting film so formed was separated from the steel belt. This film was held on a pin tenter, exposed to a stream of nitrogen at 200°C in a drying oven having a length of 1 meter, and then heated in an infrared heater oven having a length of 3 meters and controlled in such a way that a thermocouple positioned in contact with a surface of the film indicated a temperature of 350°C. An atmosphere of nitrogen was maintained in the infrared heater oven.

Properties of the continuous film thus obtained are shown in Table 2.

Comparative Examples 3 to 7

Films were produced by employing the same procedures and conditions as described in Examples 3—7, respectively, except that the heating was carried out at 250°C. Properties of the films thus obtained are shown in Table 2.

Comparative Example 8

A polymer solution was prepared in the same manner as described in Examples 1 and cast on a glass plate. This glass plate was placed on a hot plate and dried at 100°C until the volatile content of the film was reduced to 42% by weight. The self-supporting film so formed was separated from the glass plate, stretched over a metal frame having pins set therein, and then heated in a stream of air at 350°C for 60 minutes. The film thus obtained was porous and brittle.

TABLE 1

| | Starting material formulation | | | | | | Copoly-merization method |
|---|---|---|---|---|---|---|---|
| | Polyamide moiety | | | Polyamide acid moiety | | | |
| | Dicarboxylic acid dichloride (g) | Diamine (g) | $\overline{M}_{PA}$ | Tetracarbox-ylic acid dianhydride (g) | Diamine (g) | $\overline{M}_{PAA}$ | |
| Example 1 | I/TPC, 4.91 | DAE, 6.84 | 1,000 | PMDA, 27.1 | DAE, 22.9 | 5,000 | Block-block |
| Example 2 | I/TPC, 4.91 | DAE, 6.84 | 1,000 | PMDA, 27.1 | DAE, 22.9 | 5,000 | Block-block |
| Example 3 | I/TPC, 29.6 | DAE, 31.1 | 5,000 | BTDA, 32.1 | DAE, 17.9 | 5,000 | Monomer-block |
| Example 4 | I/TPC, 4.91 | DAE, 6.84 | 1,000 | BTDA, 32.1 | DAE, 17.9 | 5,000 | Block-block |
| Example 5 | IPC, 29.6 | DAE, 31.1 | 5,000 | PMDA, 27.1 | DAE, 22.9 | 5,000 | Block-block |
| Example 6 | I/TPC, 41.7 | MPD, 23.3 | 5,000 | PMDA, 27.1 | DAE, 22.9 | 5,000 | Block-block |
| Example 7 | I/TPC, 2,954 | DAE, 3,110 | 5,000 | PMDA, 2,712 | DAE, 2,288 | 5,000 | Block-block |

TABLE 1 (Cont'd)

| Logarithmic viscosity number $\eta_{inh}$ | Casting method | Method of conversion into a self-supporting film | Residual solvent content before heating (wt.%) | Heating conditions | | | |
|---|---|---|---|---|---|---|---|
| | | | | Temperature (°C) | Time (min.) | Atmosphere | Heating means |
| 1.56 | Batchwise | Heating | 0.4 | 350 | 60 | Air | Hot air |
| 1.56 | Batchwise | Heating | 0.4 | 450 | 1 | Air | Hot air |
| 1.07 | Batchwise | Heating | 0.4 | 350 | 60 | Air | Hot air |
| 1.20 | Batchwise | Cyclization | 15.0 | 350 | 60 | $N_2$ | Hot air |
| 1.10 | Batchwise | Heating | 0.4 | 320 | 15 | Air | Hot air |
| 1.01 | Batchwise | Extraction | 0.3 | 320 | 15 | $N_2$ | Infrared heater |
| 1.62 | Continuous | Heating | 3.0 | 350 | 10 | $N_2$ | Infrared heater |

TABLE 1 (Cont'd)

| | |
|---|---|
| Comparative Example 1 | Same as in Example 1 |
| Comparative Example 2 | Same as in Example 1 |
| Comparative Example 3 | Same as in Example 3 |
| Comparative Example 4 | Same as in Example 4 |
| Comparative Example 5 | Same as in Example 5 |
| Comparative Example 6 | Same as in Example 6 |
| Comparative Example 7 | Same as in Example 7 |
| Comparative Example 8 | Same as in Example 1 |

TABLE 1 (Cont'd)

| | | | | |
|---|---|---|---|---|
| Same as in Example 1 | | 300 | 60 | Same as in Example 1 |
| Same as in Example 1 | | 340 | 100 | Same as in Example 1 |
| Same as in Example 3 | | 250 | 60 | Same as in Example 3 |
| Same as in Example 4 | | 250 | 60 | Same as in Example 4 |
| Same as in Example 5 | | 250 | 15 | Same as in Example 5 |
| Same as in Example 6 | | 250 | 15 | Same as in Example 6 |
| Same as in Example 7 | | 250 | 10 | Same as in Example 7 |
| Same as in Example 1 | 42 | Same as in Example 1 | | |

(Notes)

The abbreviations used in Table 1 have the following meanings:

I/TPC = a 50:50 mixture of isophthaloyl dichloride and terephthaloyl dichloride.
IPC = isophthaloyl dichloride.
DAE = 4,4'-diaminodiphenyl ether.
MPD = m-phenylenediamine.
PMDA= pyromellitic acid dianhydride.
BTDA = 3,3',4,4'-benzophenonetetracarboxylic acid dianhydride.

The molecular weights of polymer blocks are expressed as follows:

$\overline{M}_{PA}$ = average molecular weight of polyamide blocks.
$\overline{M}_{PAA}$ = average molecular weight of polyamide acid blocks.

TABLE 2

| | Tensile break strength ($kg/mm^2$) | Tensile elongation (%) | Thermal resistance to solder (260°C, 30 sec.) | Glass transition temperature $T_g$(°C) | Electron spin $S_p$(−) | Residual solvent content (wt.%) |
|---|---|---|---|---|---|---|
| Example 1 | 17.4 | 78 | Unchanged | 345 | 2.5 | 0.004 |
| Example 2 | 17.8 | 72 | Unchanged | 350 | 3.3 | 0.05 |
| Example 3 | 11.4 | 29 | Unchanged | 272 | 2.4 | 0.004 |
| Example 4 | 12.8 | 37 | Unchanged | 275 | 2.4 | 0.004 |
| Example 5 | 9.2 | 18 | Unchanged | 270 | 2.3 | 0.009 |
| Example 6 | 8.6 | 15 | Unchanged | 271 | 2.3 | 0.009 |
| Example 7 | 14.0 | 64 | Unchanged | 284 | 2.4 | 0.005 |
| Comparative Example 1 | 14.7 | 63 | Wrinkled | 278 | 2.1 | 0.02 |
| Comparative Example 2 | 13.8 | 41 | Unchanged | 341 | 2.4 | 0.004 |
| Comparative Example 3 | 9.5 | 18 | Wrinkled | 266 | 1.6 | 0.10 |

TABLE 2 (Cont'd)

| | Tensile break strength ($kg/mm^2$) | Tensile elongation (%) | Thermal resistance to solder (260°C, 30 sec.) | Glass transition temperature $T_g$(°C) | Electron spin $S_p$(−) | Residual solvent content (wt.%) |
|---|---|---|---|---|---|---|
| Comparative Example 4 | 9.8 | 21 | Wrinkled | 269 | 1.6 | 0.10 |
| Comparative Example 5 | 8.5 | 12 | Wrinkled | 251 | 1.6 | 0.11 |
| Comparative Example 6 | 6.1 | 6 | Wrinkled | 264 | 1.6 | 0.11 |
| Comparative Example 7 | 12.9 | 55 | Wrinkled | 274 | 1.5 | 0.08 |
| Comparative Example 8 | Porous and brittle | | | | | |

**Claims**

1. A process for producing polyamide-polyimide block copolymer films or polyamide-polyimide copolymer films which comprises (1) casting on a substrate

(a) a solvent solution of a polyamide-polyamide acid block copolymer having repeating structural units of the formula

$$-[(A)-(E)]_n- \qquad (I)$$

where n represents a whole number of 1 to 500, A represents a polyamide block having structural units of the formula

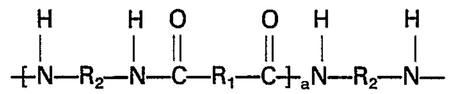

(II)

or

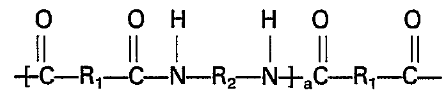

(III)

and E represents a polyamide acid block having structural units of the formula

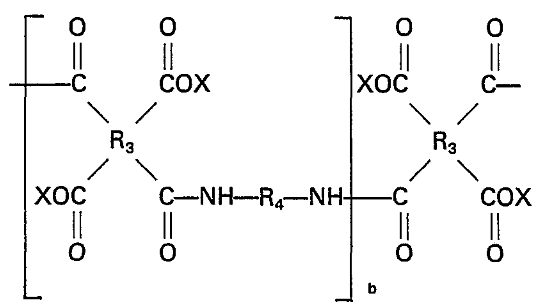

(IV)

or

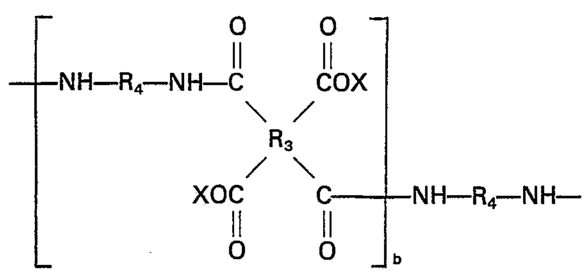

(V)

or

(b) a solvent solution of a polyamide-polyamide acid copolymer obtained by reacting a polyamide acid of the formula

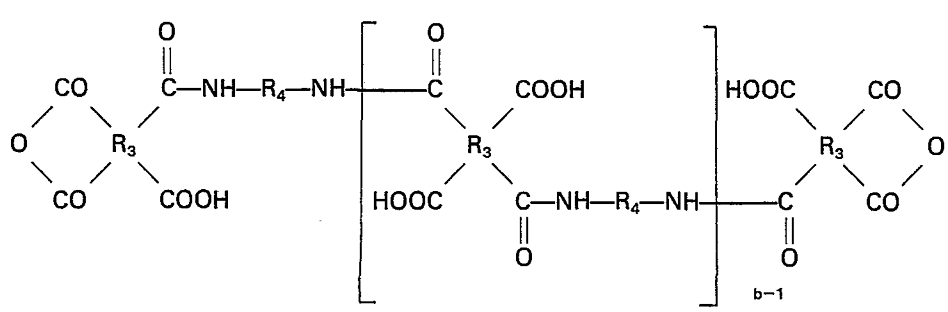

(VI)

or

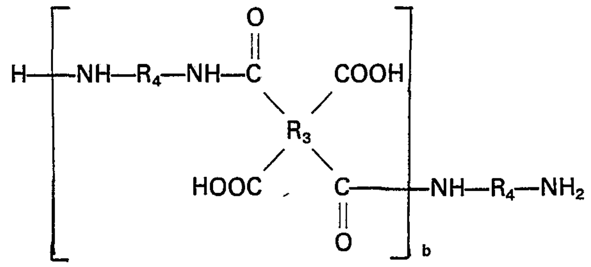

(VII)

with a dicarboxylic acid dichloride of the formula

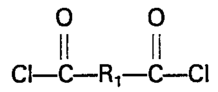

(IX)

and a diamine of the formula

$H_2N—R_2—NH_2$ (X)

where, in the formulas (II) to (X), a and b independently represent whole numbers of 2 to 100, $R_2$ and $R_4$ independently represent monocyclic aromatic groups which may be substituted with one or more halogen atoms, alkyl groups of 1 to 4 carbon atoms, or alkoxy groups of 1 to 4 carbon atoms, unfused bicyclic aromatic groups in which the aromatic nuclei are linked together by the bridge number —O—, —$CH_2$—, —CO— or —$SO_2$— and they may be substituted with one or more halogen atoms, alkyl groups of 1 to 4 carbon atoms or alkoxy groups of 1 to 4 carbon atoms, hetercyclic groups, alkylene groups of 2 to 12 carbon atoms, or dicyclohexylmethane groups, $R_1$ represents an aromatic group, a heterocyclic group or an alkylene group of 2 to 8 carbon atoms in which the carbonyl groups are bonded to different carbon atoms, $R_3$ represents a five- or six-membered cycloalkyl group, a benzene ring or an unfused bicyclic aromatic group in which the aromatic nuclei are linked together by the bridge member —O—, —CO— or —CONH— and the carbonyl groups are bonded to different ring carbon atoms that are adjacent in pairs, and X represents a halogen atom or an alkyl group of 1 to 4 carbon atoms;

(2) converting the deposited thin layer of the solution into a self-supporting film; (3) separating the self-supporting film from the substrate; and characterized by (4) heating the self-supporting film having a residual solvent content of 40% by weight or less at a temperature of 320° to 500°C for a period of time ranging from 5 seconds to 90 minutes.

2. A process as claimed in claim 1 wherein the solvent is N,N-dimethylacetamide, N,N-diethylacetamide, N,N-dimethylformamide, N,N-dimethylmethoxyacetamide, N-methyl-2-pyrrolidone, N-acetyl-2-pyrrolidone, N-methyl-ε-caprolactam, hexamethylphosphoric acid triamide (commonly known as hexametapol), N,N,N',N'-tetramethylurea, tetrahydrothiophene dioxide (commonly known as sulfolane), m-chlorophenol, p-chlorophenol, 3-chloro-6-hydroxytoluene or sulfuric acid.

3. A process as claimed in claim 1 wherein the self-supporting film is formed by heating the thin layer of the polyamide-polyamide acid block copolymer or polyamide-polyamide acid copolymer solution at a temperature of 50° to 250°C.

4. A process as claimed in claim 1 wherein the self-supporting film is formed by cyclizing the thin layer of the polyamide-polyamide acid block copolymer or polyamide-polyamide acid copolymer solution in the presence of a cyclizing agent.

5. A process as claimed in claim 1 wherein the self-supporting film is formed by bringing an extractant into contact with the thin layer of the polyamide-polyamide acid block copolymer or polyamide-polyamide acid copolymer solution to extract and remove the solvent from the thin layer.

6. A process as claimed in claim 1 wherein the self-supporting film separated from the substrate is heated at a temperature of 340° to 450°C.

7. A process as claimed in claim 1 wherein the self-supporting film separated from the substrate is heated at a temperature of 320° to 500°C in a vacuum or in an atmosphere of an inert gas.

8. A process as claimed in any of claims 1, 6 and 7 wherein the self-supporting film separated from the substrate is heated on both sides.

9. A process as claimed in claim 1 wherein, prior to heating the self-supporting film separated from the substrate at a temperature of 320° to 500°C, the residual solvent content of the film is reduced to 40% by weight or less by heating at temperatures lower than 320°C evaporation under reduced pressure, extraction or air-drying.

10. A process as claimed in claim 9 wherein the residual solvent content is 20% by weight or less.

11. A process as claimed in claim 9 wherein the residual solvent content is 5% by weight or less.

12. A process as claimed in claim 1 wherein the polyamide-polyamide acid block copolymer or polyamide-polyamide acid copolymer has a logarithmic viscosity number of 0.1 to 3 as measured by a 0.5 g/100 ml solution in N,N-dimethylacetamide at 35°C.

13. A process as claimed in claim 12 wherein the logarithmic viscosity number is in the range of 0.5 to 2.

**Patentansprüche**

1. Verfahren zum Herstellen von Polyamid-Polyimid-Blockcopolymer-Folien oder Polyamid-Polyimid-Copolymer-Folien, das das (1) Gießen auf einen Träger (a) einer Lösungsmittellösung von einem Polyamid-Polyamidsäure-Blockcopolymer mit wiederkehrenden Struktureinheiten der Formel

$$-[(A)-(E)]_n- \qquad (I)$$

worin n eine ganze Zahl von 1 bis 500 darstellt, A einen Polyamidblock mit Struktureinheiten der Formel

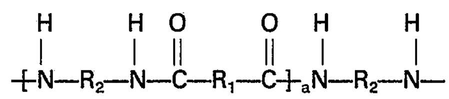

(II)

oder

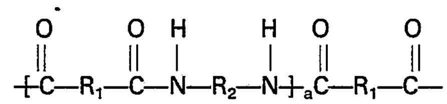

(III)

darstellt, und E einen Polyamidsäure-Block mit Struktureinheiten der Formel

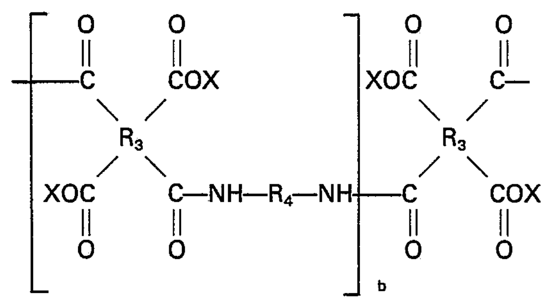

(IV)

oder

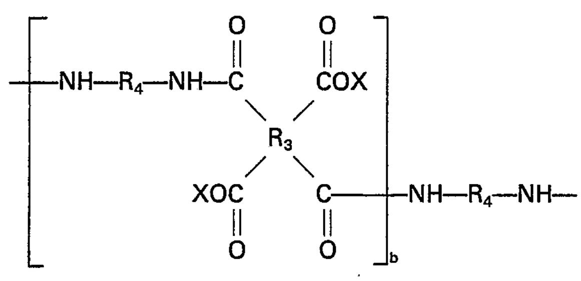

(V)

darstellt, oder

(b) einer Lösungsmittellösung eines Polyamid-Polyamidsäure-Copolymeren, das durch Umsetzen einer Polyamidsäure der Formel

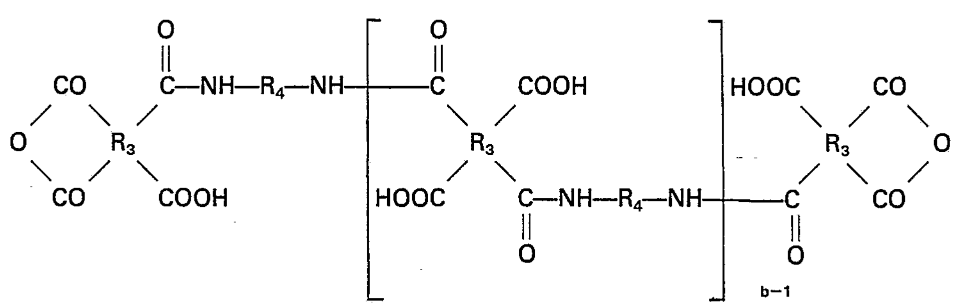

(VI)

oder

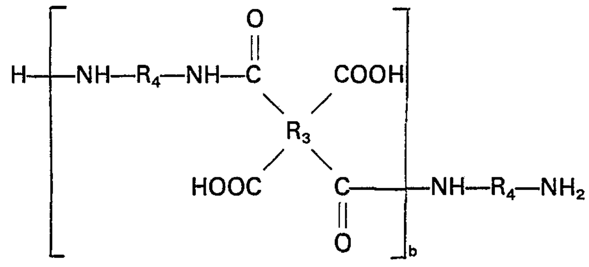

(VII)

mit einem Dicarbonsäuredichlorid der Formel

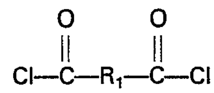

(IX)

und einem Diamin der Formel

$$H_2N—R_2—NH_2 \quad (X)$$

erhalten wird, wobei in den Formeln (II) bis (X) a und b unabhängig voneinander ganze Zahlen von 2 bis 100 darstellen, $R_2$ und $R_4$ unabhängig voneinander monocyclische aromatische Gruppen, die mit einem oder mehreren Halogenatomen, Alkylgruppen mit 1 bis 4 Kohlenstoffatomen oder Alkoxygruppen mit 1 bis 4 Kohlenstoffatomen substituiert sein können, unverschmolzene bicyclische aromatische Gruppen, in denen die aromatischen Kerne durch das Brückenglied —O—, $—CH_2—$, —CO— oder $—SO_2—$ miteinander verbunden sind und die mit einem oder mehreren Halogenatomen, Alkylgruppen mit 1 bis 4 Kohlenstoffatomen oder Alkoxygruppen mit 1 bis 4 Kohlenstoffatomen substituiert sein können, heterocyclische Gruppen, Alkylengruppen mit 2 bis 12 Kohlenstoffatomen oder Dicyclohexylmethangruppen darstellen, $R_1$ eine aromatische Gruppe, eine heterocyclische Gruppe oder eine Alkylengruppe mit 2 bis 8 Kohlenstoffatomen, in denen die Carbonylgruppen an verschiedene Kohlenstoffatome gebunden sind, darstellt, $R_3$ eine fünf- oder sechs-gliedrige Cycloalkylgruppe, einen Benzolring oder eine unverschmolzene bicyclische aromatische Gruppe, in der die aromatischen Kerne durch das Brückenglied —O—, —CO— oder —CONH— miteinander verbunden sind und die Carbonylgruppen an verschiedene Ringkohlenstoffatome gebunden sind, die in Paaren benachbart sind, darstellt und X ein Wasserstoffatom oder eine Alkylgruppe mit 1 bis 4 Kohlenstoffatomen darstellt; (2) Umwandeln der abgelagerten dünnen Schicht aus der Lösung in eine selbsttragende Folie und (3) Abtrennen der selbsttragenden Folie von dem Träger umfaßt und dadurch gekennzeichnet ist, daß (4) die selbsttragende Folie mit einem Rest-Lösungsmittelgehalt von 40 Gew.-% oder weniger bei einer Temperatur von 320° bis 500°C über eine Zeitdauer, die von 5 Sekunden bis 90 Minuten reicht, erhitzt wird.

2. Verfahren nach Anspruch 1, bei dem das Lösungsmittel N,N-Dimethylacetamid, N,N-Diäthylacetamid, N,N-Dimethylformamid, N,N-Dimethylmethoxyacetamid, N-Methyl-2-pyrrolidon, N-Acetyl-2-pyrrolidon, N-Methyl-ε-Caprolactam, Hexamethylphosphorsäuretriamid (allgemein bekannt als Hexametapol), N,N,N',N'-Tetramethylharnstoff, Tetrahydrothiophendioxid (allgemein bekannt als Sulfolan), m-Chlorphenol, p-Chlorphenol, 3-Chor-6-hydroxytoluol oder Schwefelsäure ist.

3. Verfahren nach Anspruch 1, bei dem die selbsttragende Folie durch Erhitzen der dünnen Schicht aus der Polyamid-Polyamidsäure-Blockcopolymer- oder Polyamid-Polyamidsäure-Copolymer-Lösung bei einer Temperatur von 50° bis 250°C gebildet wird.

4. Verfahren nach Anspruch 1, bei dem die selbsttragende Folie durch Cyclisieren der dünnen Schicht aus der Polyamid-Polyamidsäure-Blockcopolymer- oder Polyamid-Polyamidsäure-Copolymer-Lösung in Anwesenheit eines Cyclisierungsmittels gebildet wird.

5. Verfahren nach Anspruch 1, bei dem die selbsttragende Folie durch Inkontaktbringen eines Extraktionsmittels mit der dünnen Schicht aus der Polyamid-Polyamidsäure-Blockcopolymer- oder Polyamid-Polyamidsäure-Copolymer-Lösung, um das Lösungsmittel von der dünnen Schicht zu extrahieren und zu entfernen, gebildet wird.

6. Verfahren nach Anspruch 1, bei dem die von dem Träger abgelöste selbsttragende Folie auf eine Temperatur von 340° bis 450°C erhitzt wird.

7. Verfahren nach Anspruch 1, bei dem die von dem Träger abgelöste selbsttragende Folie auf eine Temperatur von 320° bis 500°C in einem Vakuum oder in einer Atmosphäre aus einem inerten Gas erhitzt wird.

8. Verfahren nach einem der Ansprüche 1, 6 und 7, bei dem die von dem Träger abgelöste selbsttragende Folie auf beiden Seiten erhitzt wird.

9. Verfahren nach Anspruch 1, bei dem vor dem Erhitzen der von dem Träger abgelösten Folie bei einer Temperatur von 320° bis 500°C der Rest-Lösungsmittelgehalt der Folie auf 40 Gew.-% oder weniger durch Erhitzen bei Temperaturen, die niedriger als 320°C sind, Verdampfen unter Unterdruck, Extraktion oder Lufttrocknung gesenkt wird.

10. Verfahren nach Anspruch 9, bei dem der Rest-Lösungsmittelgehalt 20 Gew.-% oder weniger ist.

11. Verfahren nach Anspruch 9, bei dem der Rest-Lösungsmittelgehalt 5 Gew.-% oder weniger ist.

12. Verfahren nach Anspruch 1, bei dem das Polyamid-Polyamidsäure-Blockcopolymer oder das Polyamid-Polyamidsäure-Copolymer eine logarithmische Viskositätszahl von 0,1 bis 3, gemessen durch eine 0,5 g/100 ml-Lösung in N,N-Dimethylacetamid bei 35°C, aufweist.

13. Verfahren nach Anspruch 12, bei dem die logarithmische Viskositätszahl in dem Bereich von 0,5 bis 2 liegt.

## Revendications

1. Un procédé pour la production de pellicules de copolymères séquencés de polyamide-polyimide ou de pellicules de copolymères de polyamide-polyimide qui comprend (1) la coulée sur un substrat de

(a) une solution dans un solvant d'un cooplymère séquencé de polyamide-(polyamide-acide) ayant des motifs structuraux répétés de formule

$$-[(A)-(E)]_n- \qquad (I)$$

dans laquelle n représente un nombre entier de 1 à 500. A représente une séquence de polyamide ayant des motifs structuraux de formule

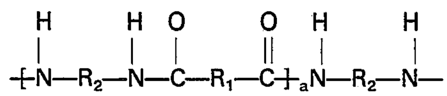
(II)

ou

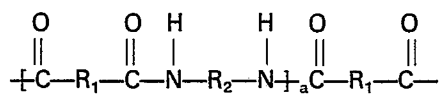
(III)

et E représente une séquence de polyamide-acide ayant des motifs structuraux de formule

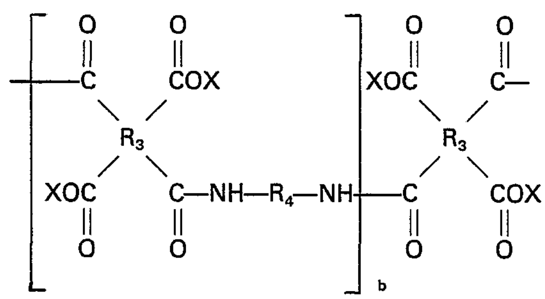
(IV)

ou

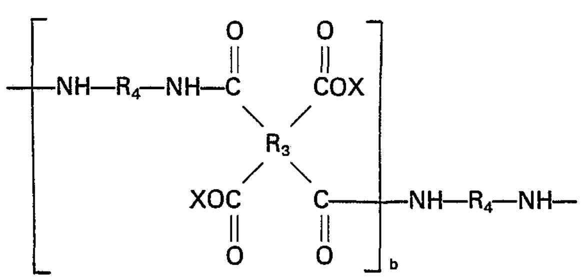
(V)

ou

(b) une solution dans un solvant d'un copolymère de polyamide-(polyamide-acide) obtenu par réaction d'un polyamide-acide de formule

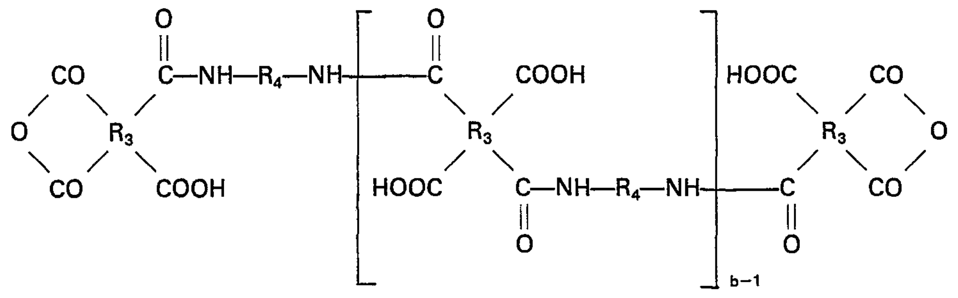 (VI)

ou

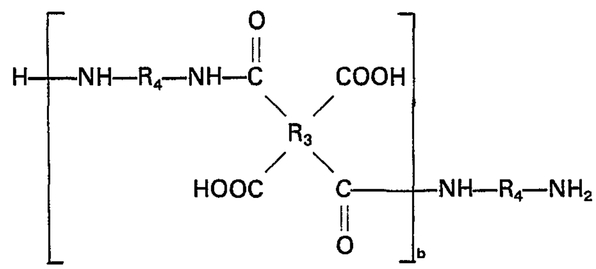 (VII)

avec un dichlorure d'acide dicarboxylique de formule

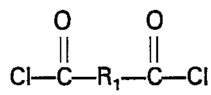 (IX)

et une diamine de formule

$$H_2N—R_2—NH_2 \quad (X)$$

où, dans les formules (II) à (X), a et b indépendamment représentent des nombres entiers de 2 à 100, $R_2$ et $R_4$ indépendamment représentent des groupes aromatiques monocycliques qui peuvent être substitués par un ou plusieurs atomes d'halogène, groupes alcoyles de 1 à 4 atomes de carbone ou groupes alcoxy de 1 à 4 atomes de carbone, des groupes aromatiques bicycliques non condensés dans lesquels les noyaux aromatiques sont unis ensemble par l'élément de pontage —O—, $—CH_2—$, —CO— ou $—SO_2—$ et peuvent être substitués par un ou plusieurs atomes d'halogène, groupes alcoyles de 1 à 4 atomes de carbone ou groupes alcoxy de 1 à 4 atomes de carbone, des groupes hétérocycliques, des groupes alcoylènes de 2 à 12 atomes de carbone ou des groupes dicyclohexylméthanes, $R_1$ représente un groupe aromatique, un groupe hétérocyclique ou un groupe alcoylène de 2 à 8 atomes de carbone dans lequel les groupes carbonyles sont unis à des atomes de carbone différents, $R_3$ représente un groupe cycloalcoyle à 5 ou 6 chaînons, un cycle benzène ou un groupe aromatique bicyclique non condensé dont les noyaux aromatiques sont unis ensemble par l'élément de pontage —O—, —CO— ou —CONH— et les groupes carbonyles sont unis à des atomes de carbone cycliques différents qui sont adjacents par paires et X représente un atome d'hydrogène ou un groupe alcoyle de 1 à 4 atomes de carbone; (2) la conversion de la pellicule mince déposée de la solution en une pellicule autoportante; (3) la séparation de la pellicule autoportante d'avec le substrat; et caractérisé par (4) le chauffage de la pellicule autoportante ayant une teneur en solvant résiduel de 40% en poids ou moins à une température de 320° à 500°C pendant une période comprise dans la gamme de 5 secondes à 90 minutes.

2. Un procédé comme revendiqué dans la revendication 1 dans lequel le solvant est le N,N-diméthylacétamide, le N,N-diéthylacétamide, le N,N-diméthylformamide, le N,N-diméthylméthoxy-acétamide, la N-méthyl-2-pyrrolidone, la N-acétyl-2-pyrrolidone, le N-méthyl-ε-caprolactame, le triamide de l'acide hexaméthylphosphorique (appelé couramment hexamétapol), la N,N,N',N'-tétraméthylurée, le dioxyde de tétrahydrothiophène (appelé couramment sulfolane), le m-chlorophénol, le p-chlorophénol, le 3-chloro-6-hydroxytoluène ou l'acide sulfurique.

3. Un procédé comme revendiqué dans la revendication 1 dans lequel la pellicule autoportante est formée par chauffage de la couche mince de la solution de copolymère séquencé de polyamide-(polyamide-acide) ou de copolymère de polyamide-(polyamide-acide) à une température de 50° à 250°C.

4. Un procédé comme revendiqué dans la revendication 1 dans lequel la pellicule autoportante est formée par cyclisation de la couche mince de la solution de copolymère séquencé de polyamide-(polyamide-acide) ou de copolymère de polyamide-(polyamide-acide) en présence d'un agent cyclisant.

5. Un procédé comme revendiqué dans la revendication 1 dans lequel la pellicule autoportante est formée par mise d'un extractant en contact avec la couche mince de la solution de copolymère séquencé de

polyamide-(polyamide-acide) ou de copolymère de polyamide-(polyamide-acide) pour extraire et éliminer le solvant de la couche mince.

6. Un procédé comme revendiqué dans la revendication 1 dans lequel la pellicule autoportante séparée du substrat est chauffée à une température de 340° à 450°C.

7. Un procédé comme revendiqué dans la revendication 1 dans lequel la pellicule autoportante séparée du substrat est chauffée à une température de 320° à 500°C sous vide ou dans une atmosphère d'un gaz inerte.

8. Un procédé comme revendiqué dans l'une quelconque des revendications 1, 6 et 7 dans lequel la pellicule autoportante séparée du substrat est chauffée des deux côtés.

9. Un procédé comme revendiqué dans la revendication 1 dans lequel, avant le chauffage de la pellicule autoportante séparée du substrat à une température de 320° à 500°C, la teneur en solvant résiduel de la pellicule est réduite à 40% en poids ou moins par chauffage à des températures inférieures à 320°C, évaporation sous pression réduite, extraction ou séchage à l'air.

10. Un procédé comme revendiqué dans la revendication 9 dans lequel le teneur en solvant résiduel est de 20% en poids ou moins.

11. Un procédé comme revendiqué dans la revendication 9 dans lequel la teneur en solvant résiduel est de 5% en poids ou moins.

12. Un procédé comme revendiqué dans la revendication 1 dans lequel le copolymère séquencé de polyamide-(polyamide-acide) ou copolymère de polyamide-(polyamide-acide) a un indice de viscosité logarithmique de 0,1 à 3 comme mesuré avec une solution à 0,5 g/100 ml dans le N,N-diméthylacétamide à 35°C.

13. Un procédé comme revendiqué dans la revendication 12 dans lequel l'indice de viscosité logarithmique est dans la gamme de 0,5 à 2.